# EUROPEAN PATENT APPLICATION

(11) **EP 4 637 283 A1**
(43) Date of publication of application: **22.10.2025**
(21) Application number: 24198361.8
(22) Date of filing: 04.09.2024
(51) Int. Cl.: H05K 7/14, H05K 7/20

(54) **POWER ELECTRONIC DEVICE AND POWER SYSTEM**

(30) Priority: 15.04.2024 CN 202420778014 U
(71) Applicant: Sungrow (Shanghai) Co., Ltd., Shanghai 201203 (CN)
(72) Inventor: QIAO, Kai, Shanghai, 201203 (CN); ZHANG, Jialiang, Shanghai, 201203 (CN); ZHAO, Bo, Shanghai, 201203 (CN)
(74) Representative: Rooney, John-Paul

(57) **Abstract**

A power electronic device and a power system are provided. The present application relates to the technical field of electrical technologies. The power electronic device includes a first housing, a second housing, a circuit board assembly and a first connector. The first housing is provided with a heat dissipation structure. The first housing and the second housing enclose to form a mounting cavity, and the circuit board assembly is accommodated inside the mounting cavity. The circuit board assembly includes a circuit board and a power device being mounted to the circuit board. The first connector passes through the first housing from outside to inside and is connected to the circuit board to fix the circuit board at an inner side of the first housing. In a case that the circuit board is fixed at the inner side of the first housing, the first housing contacts the circuit board assembly in a region corresponding to the power device, and the heat dissipation structure at least covers the region of the first housing corresponding to the power device. The present application can satisfy the heat dissipation requirement of the power device of the circuit board assembly and the mounting convenience requirement of the circuit board assembly of the power electronic device at the same time, and is beneficial to compact structural design of the circuit board assembly.

## Description

### FIELD

The present application relates to the technical field of electrical technologies, and in particular to a power electronic device and a power system.

### BACKGROUND

A housing of a power electronic device, such as an inverter and the like, generally includes a first housing and a second housing, a mounting cavity is formed by enclosure of the first housing and the second housing, and a circuit board assembly of the power electronic device is mounted inside the mounting cavity. At present, when the power electronic device is being assembled, the circuit board assembly is tightly pressed against the first housing by a fastener at a side of the circuit board assembly away from the first housing at first, and a power device of the circuit board assembly is made close to a region on the first housing where a heat dissipation structure is located, so as to facilitate heat dissipation of the power device; then the second housing is connected to the first housing by another fastener.

However, with this arrangement, when the circuit board assembly is being mounted, the fastener and the corresponding operation device are required to avoid the second housing, to prevent collision with the second housing. To be more specific, the second housing has to be removed first; after the circuit board assembly and the first housing are connected by the fastener, the second housing is moved to cover the side of the circuit board assembly away from the first housing; and then the second housing is connected to the first housing. The mounting process of the circuit board assembly is relatively cumbersome, leading to low assembling efficiency of the power electronic device. As a result, the heat dissipation requirement of the power device and the mounting convenience requirement of the circuit board assembly cannot be satisfied at the same time.

### SUMMARY

An object of the present application is to solve the problem in the prior art that the heat dissipation requirement of a power device of a circuit board assembly and the mounting convenience requirement of the circuit board assembly of a power electronic device cannot be satisfied at the same time.

To solve at least one aspect of the above problem, in a first aspect of the present application, a power electronic device is provided, including a first housing, a second housing, a circuit board assembly and a first connector. The first housing is provided with a heat dissipation structure. A mounting cavity is defined by the first housing and the second housing, and the circuit board assembly is accommodated inside the mounting cavity. The circuit board assembly includes a circuit board and a power device being mounted to the circuit board. The first connector passes through the first housing from outside to inside and is connected to the circuit board, to fix the circuit board at an inner side of the first housing. When the circuit board is fixed at the inner side of the first housing, the first housing is in contact with the circuit board assembly in a region corresponding to the power device, and the heat dissipation structure covers at least the region of the first housing corresponding to the power device.

In an embodiment, in a thickness direction of the circuit board, the power device is mounted at a side of the circuit board facing the first housing.

In an embodiment, the first connector includes at least one of a first setting connector and a second setting connector. A projection of the first setting connector on the circuit board is located at an outer peripheral edge surrounding a projection of the power device on the circuit board, and the second setting connector is arranged at a peripheral edge of the circuit board.

In an embodiment, a support structure is provided at the inner side of the first housing, and the circuit board is supported by the first housing through the support structure. The support structure includes at least one of a first support structure and a second support structure. A projection of the first support structure on the circuit board is located at the outer peripheral edge surrounding the projection of the power device on the circuit board, and the second support structure is arranged corresponding to the peripheral edge of the circuit board.

In an embodiment, the first support structure includes at least one of a first support rod and a first support plate, and the first support plate extends along a peripheral direction of the power device; and/or, the second support structure includes a second support rod.

In an embodiment, in a case that the first connector includes the first setting connector, and the support structure includes the first support structure and the second support structure, a distance between an end face of the first support structure and the second housing is larger than or equal to a distance between an end face of the second support structure and the second housing.

In an embodiment, the support structure is provided with a first connection hole for the first connector to pass through.

In an embodiment, the circuit board includes a circuit board body and a reinforcement structure being connected to the circuit board body. At least one of the circuit board body and the reinforcement structure is connected to the first connector.

In an embodiment, the reinforcement structure includes a reinforcement plate, and the reinforcement plate and the power device are respectively located at opposite sides of the circuit board body in a thickness direction, or the reinforcement plate and the power device are located at a same side of the circuit board body in a thickness direction. A projection of the power device on the circuit board body is within a projection of the reinforcement plate on the circuit board body.

In an embodiment, the first housing and the second housing are connected by snap fit; and/or the power electronic device further includes a second connector, and the first housing and the second housing are connected through the second connector.

In an embodiment, in a case that the power electronic device includes the second connector, the second connector passes through the first housing and is connected to the second housing. The second housing is provided with a through hole to be connected to the second connector, or an inner side of the second housing is provided with a blind hole to be connected to the second connector.

In an embodiment, the power electronic device further includes an insertion positioning structure. The insertion positioning structure is provided between the first housing and the circuit board, and/or the insertion positioning structure is provided between the first housing and the second housing.

In an embodiment, the insertion positioning structure includes a positioning pin and multiple positioning holes. Each of the first housing, the circuit board and the second housing is provided with one of the multiple positioning holes, and the positioning pin is inserted into the corresponding positioning holes of at least two of the first housing, the circuit board and the second housing.

In an embodiment, the heat dissipation structure includes multiple heat dissipation fins connected to an outer surface of the first housing, or a heat dissipation flow passage, or a combination of multiple heat dissipation fins connected to an outer surface of the first housing and a heat dissipation flow passage. And/or, the first connector is a threaded connector or a snap-fit connector. And/or, the second housing includes a first plate and a second plate, the first plate is arranged facing the circuit board, the second plate is located at an end of the first plate, and the second plate is provided with a mounting hole for mounting a cable bundle assembly.

In a second aspect of the present application, a power system is provided, including the power electronic device according to the first aspect hereinabove.

Compared with related prior art, in the power electronic device and the power system according to the present application, the circuit board assembly is fixed by the first connector from the outer side of the first housing provided with the heat dissipation structure. Under the action of the first connector, the first housing is in contact with the circuit board assembly in the region corresponding to the power device, to form a thermal conduction path, which can ensure the heat dissipation performance on the power device of the circuit board assembly. Meanwhile, it is avoided to perform connection operation of the circuit board assembly at the inner side of the first housing, which reduces a possibility of colliding with the second housing during the connection operation between the first housing and the circuit board assembly. For example, there's no need to remove the second housing and perform the connection between the circuit board assembly and the first housing at the side of the circuit board assembly away from the first housing in the thickness direction, which facilitates subsequent quick connection between the first housing and the second housing. For example, after the first housing, the circuit board assembly and the second housing are positioned relative to one another, the first housing and the circuit board assembly can be quickly connected, and the first housing and the second housing can also be quickly connected. For example, the first housing and the second housing may be connected by snap fit or by the second connector. According to the present application, the heat dissipation requirement of the power device of the circuit board assembly and the mounting convenience requirement of the circuit board assembly of the power electronic device can be satisfied at the same time. In addition, with this arrangement, a reserved operation space at the side of the circuit board assembly away from the first housing in the thickness direction (a reserved operation space for the connection operation between the circuit board assembly and the first housing) is less demanded, which is beneficial to compact structural design of the circuit board assembly, thereby increasing space utilization of the power electronic device.

### BRIEF DESCRIPTION OF THE DRAWINGS

FIG. 1 is a schematic exploded view showing the structure of a power electronic device according to an embodiment of the present application;
FIG. 2 is another schematic view showing the structure of the power electronic device according to the embodiment of the present application;
FIG. 3 is yet another schematic view showing the structure of the power electronic device according to the embodiment of the present application;
FIG. 4 is a schematic sectional view along a cross section A-A in FIG. 3;
FIG. 5 is a schematic sectional view along a cross section B-B in FIG. 3;
FIG. 6 is a schematic exploded view showing the structure of a power electronic device according to another embodiment of the present application in a case that a reinforcement structure is embodied as a reinforcement plate; and
FIG. 7 is a schematic structural view showing a connection between a first connector and the reinforcement plate according to the embodiment corresponding to FIG. 6.

### Reference numerals:

| | | | |
|---|---|---|---|
| 1 | first housing, | 11 | first connection hole, |
| 12 | third connection hole, | 13 | first support structure, |
| 14 | second support structure, | 15 | lug structure, |
| 16 | heat dissipation structure, | 2 | second housing, |
| 21 | first plate, | 22 | second plate, |
| 23 | mounting hole, | 24 | fourth connection hole, |
| 3 | circuit board assembly, | 31 | circuit board, |
| 311 | circuit board body, | 312 | reinforcement plate, |
| 32 | power device, | 33 | second connection hole, |
| 34 | T-shaped structure, | 4 | first connector, |
| 41 | first setting connector, | 42 | second setting connector, |
| 5 | second connector, | 6 | insertion positioning structure, |
| 61 | positioning pin, | 62 | positioning hole, |
| 7 | cable bundle assembly. | | |

### DETAILED DESCRIPTION OF THE EMBODIMENTS

Specific embodiments of the present application will be described clearly and completely as follows in conjunction with the accompany drawings, so that purposes, characteristics and advantages of the present application can be more obvious and understandable.

In the description of the present application, it should be noted that, unless otherwise clearly specified and limited, the terms "mount", "connected to" and "connection" should be understood in a broad sense. For example, it may be a fixed connection, a detachable connection, or an integral connection; it may be a direct connection, or an indirect connection through an intermediate medium. For those skilled in the art, the specific meanings of the above terms in the present application may be understood according to specific situations.

In the description of this specification, descriptions referring to the terms "embodiment", "one embodiment", "some solutions", "in an example", "one solution", etc., mean that specific features, structures, materials or characteristics described in conjunction with the embodiment or solution are included in at least one embodiment or solution of the present application. In this specification, schematic expressions of the above terms do not necessarily refer to the same embodiment or solution. Furthermore, the specific features, structures, materials or characteristics described may be combined in any suitable manner in any one or more embodiments or solutions.

The terms such as "first", "second" and the like are merely for description, and should not be construed as indicating or implying relative importance, or implicitly indicating the number of technical features being referred to. In this way, the feature defined by the terms "first", "second" may explicitly or implicitly include at least one such features.

In the drawings, the Z-axis denotes a vertical direction, i.e. an up-down direction, where a positive direction (i.e. a direction indicated by an arrow of the Z-axis) of the Z-axis indicates an upper side, and a negative direction of the Z-axis indicates a lower side. The X-axis denotes a front-rear direction, where a positive direction (i.e. a direction indicated by an arrow of the X-axis) of the X-axis indicates a front side, and a negative direction of the X-axis indicates a rear side. The Y-axis denotes a horizontal direction, which is referred to as a left-right direction, where a positive direction (i.e. a direction indicated by an arrow of the Y-axis) of the Y-axis indicates a right side, and a negative direction of the Y-axis indicates a left side. It should also be noted that, the meanings of the Z-axis, Y-axis and X-axis described hereinabove are merely for the convenience of describing the present application and simplifying the description, and do not indicate or imply that the device or element referred to must have a particular orientation, or be configured and operated in a particular orientation, which therefore should not be construed as a limitation to the scope of the present application.

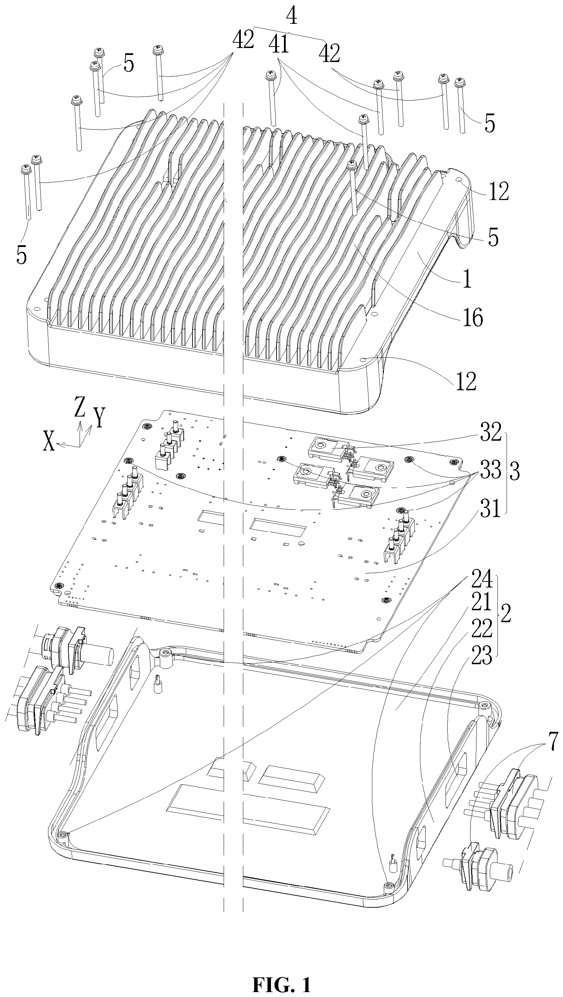

As shown in FIGS. 1 to 5, a power electronic device is provided according to an embodiment of the present application. The power electronic device includes a first housing 1, a second housing 2, a circuit board assembly 3 and a first connector 4. The first housing 1 is provided with a heat dissipation structure 16. A mounting cavity is defined by the first housing 1 and the second housing 2 being coupled to each other, and the circuit board assembly 3 is accommodated inside the mounting cavity. The circuit board assembly 3 includes a circuit board 31 and a power device 32 being mounted to the circuit board 31. The first connector 4 passes through the first housing 1 from outside to inside and is connected to the circuit board 31 to fix the circuit board 31 to an inner side of the first housing 1. In a case that the circuit board 31 is fixed at the inner side of the first housing 1, the first housing 1 is in contact with the circuit board assembly 3 in a region corresponding to the power device 32, and the heat dissipation structure 16 at least covers the region of the first housing 1 corresponding to the power device 32.

It should be noted that, in the present embodiment, the first housing 1 and the second housing 2 are distributed along the Z-axis, and they are coupled with each other to form the mounting cavity and form a relatively complete housing structure. The circuit board assembly 3 is mounted inside the mounting cavity, and a sealing structure between the first housing 1 and the second housing 2 is determined according to the requirement of the specific protection class. In actual use, the X-axis, Y-axis and Z-axis in this specification are merely for describing the structure of the power electronic device, and do not represent the mounting direction of the power electronic device in practice. For example, when the power electronic device is put into uses, the positive direction of the Y-axis may refer to an upward direction in actual space.

Specifically, the first connector 4 passes through the first housing 1 from an outer side of the first housing 1 in a direction from outside to inside, to be connected to the circuit board 31, such that the circuit board 31 is fixed at a position at the inner side of the first housing 1. An action force, such as a tensile force, applied on the first housing 1 and the circuit board 31 by the first connector 4 makes the first housing 1 be in contact with the circuit board assembly 3 in the region corresponding to the power device 32. That is to say, under the action of the first connector 4, a thermal conduction path is formed through the contact between the first housing 1 and the circuit board assembly 3, to perform heat conduction between the first housing 1 and the power device 32, so as to ensure the thermal conduction performance between a portion of the circuit board assembly 3 where the power device 32 is located and the first housing 1. At the same time, the heat dissipation structure 16 is configured to cover at least the region of the first housing 1 corresponding to the power device 32, to realize heat conduction between the power device 32 and the heat dissipation structure 16 of the first housing 1 through the thermal conduction path, so as to ensure the heat dissipation performance that heat of the power device 32 of the circuit board assembly 3 can be dissipated via the heat dissipation structure 16 of the first housing 1.

In this way, according to the present application, the circuit board assembly 3 is fixed by the first connector 4 from the outer side of the first housing 1 provided with the heat dissipation structure 16. Under the action of the first connector 4, the first housing 1 is in contact with the circuit board assembly 3 in the region corresponding to the power device 32, to form the thermal conduction path, which can ensure the heat dissipation performance on the power device 32 of the circuit board assembly 3. Meanwhile, it is avoided to perform connection operation of the circuit board assembly 3 at the inner side of the first housing 1, which reduces a possibility of colliding with the second housing 2 during the connection operation between the first housing 1 and the circuit board assembly 3. For example, there's no need to remove the second housing 2 and perform the connection between the circuit board assembly 3 and the first housing 1 at the side of the circuit board assembly 3 away from the first housing 1 in the thickness direction, which facilitates subsequent quick connection between the first housing 1 and the second housing 2. For example, after the first housing 1, the circuit board assembly 3 and the second housing 2 are positioned relative to one another, the first housing 1 and the circuit board assembly 3 can be quickly connected, and the first housing 1 and the second housing 2 can also be quickly connected. For example, the first housing 1 and the second housing 2 may be connected by snap fit or by a second connector 5. According to the present application, the heat dissipation requirement of the power device 32 of the circuit board assembly 3 and the mounting convenience requirement of the circuit board assembly 3 of the power electronic device can be satisfied at the same time. In addition, with this arrangement, a reserved operation space at the side of the circuit board assembly 3 away from the first housing 1 in the thickness direction (a reserved operation space for the connection operation between the circuit board assembly 3 and the first housing 1) is less demanded, which is beneficial to compact structural design of the circuit board assembly 3, thereby increasing space utilization of the power electronic device.

As shown in FIG. 1, in an embodiment, in a thickness direction of the circuit board 31, the power device 32 is mounted at a side of the circuit board 31 facing the first housing 1.

As shown in FIG. 1, the power device 32 is mounted at an upper side of the circuit board 31. In this way, with the connection operation of the first connector 4, an upper side wall (i.e. the side wall away from the circuit board 31) of the power device 32 can be tightly pressed onto the inner side of the first housing 1. Herein, the upper side of the circuit board 31 refers to the side of the circuit board 31 close to the inner side of the first housing 1.

Specifically, the side wall of the power device 32 away from the circuit board 31 abuts against the first housing 1. For example, the side wall of the power device 32 is fitted to and abuts against the inner side of the first housing 1, such that the first housing 1 is in contact with the power device 32 for heat conduction.

Certainly, between the side wall of the power device 32 away from the circuit board 31 and the first housing 1, a thermal conductive structure, such as a thermal conductive insulating adhesive, may be provided; alternatively, a thermal conductive structure which is relatively elastic, such as a thermal conductive insulating pad, may be provided therebetween, so as to prevent the power device 32 from being broken due to an excessive action force applied by the first connector 4.

It may be appreciated that, in other embodiments, the power device 32 may be mounted at a side of the circuit board 31 away from the first housing 1. In this case, an avoidance hole is provided in the circuit board 31 corresponding to a heat generation region of the power device 32, and the thermal conductive structure is accommodated in the avoidance hole. One end of the thermal conductive structure is fitted to the inner side of the first housing 1, and the other end is fitted to the heat generation region of the power device 32.

In this way, compared with the solution that the power device 32 is mounted at the side of the circuit board 31 away from the first housing 1, a length of the thermal conduction path corresponding to the power device 32 can be decreased, thereby improving the heat dissipation performance of the power device 32.

As shown in FIGS. 1 to 5, in an embodiment, the first connector 4 is a threaded connector or a snap-fit connector.

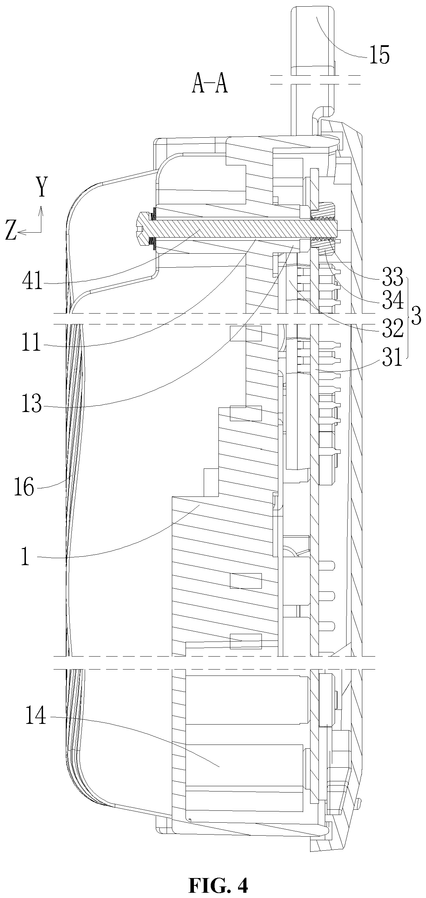

As shown in FIG. 4, specifically, the first housing 1 is provided with a first connection hole 11, and the circuit board assembly 3 is provided with a second connection hole 33. Starting from an outer side (a side where the positive direction of the Z-axis in the drawing is) of the first housing 1, the first connector 4 passes through the first connection hole 11 from outside to inside, to be connected to the second connection hole 33.

In an example, when the first connector 4 is a threaded connector, the first connector 4 passes through the first connection hole 11 and is in a threaded connection with the second connection hole 33. In this case, the second connection hole 33 may be a threaded blind hole or a threaded through hole. FIG. 4 shows a case that the second connection hole 33 is the threaded through hole, which is taken as an example hereinafter for describing the present application.

The second connection hole 33 may be formed in a T-shaped structure 34 provide at the circuit board 31. The T-shaped structure 34 has a small end and a large end opposite to each other, where the smaller end passes through the circuit board 31 from the side of the circuit board 31 away from the first housing 1.

In an example, in a case that the first connector 4 is a snap-fit connector, each of two ends of the snap-fit connector is provided with a cantilever snap joint. After the first connector 4 passes through the first connection hole 11 and extends into the second connection hole 33, the cantilever snap joints at the two ends of the first connector 4 are respectively connected to the first connection hole 11 and the second connection hole 33 by snap fit. For example, both the first connection hole 11 and the second connection hole 33 are through holes. The cantilever snap joints abut against outer end faces of the through holes respectively, such that the circuit board assembly 3 and the first housing 1 are fixed with respect to each other (this solution is not shown in the drawings).

As shown in FIGS. 1, 3, and 5, in an embodiment, the first connector 4 may be embodied as at least one of a first setting connector 41 and a second setting connector 42, the first connector 4 includes at least one of a first setting connector 41 and a second setting connector 42. A projection of the first setting connector 41 on the circuit board 31 is located at an outer peripheral edge surrounding a projection of the power device 32 on the circuit board 31, and the second setting connector 42 is arranged corresponding to a peripheral edge of the circuit board 31. Specifically, the second setting connector 42 is arranged at the peripheral edge of the circuit board.

That is to say, at least one of the first connector 4 is the first setting connector 41, and/or at least one of the first connector 4 is the second setting connector 42. Multiple first setting connectors 41 and multiple second setting connectors 42 may be provided according to needs.

It may be appreciated that, the first setting connector 41 is connected to the circuit board 31 mainly at a peripheral side of the power device 32, so as to enhance the tensile force applied on the circuit board assembly 3 at the region where the power device 32 is located. A minimum distance between the projection of the first setting connector 41 on the circuit board 31 and the projection of the power device 32 on the circuit board 31 (a minimum value of a distance between two points on outer contours of the two projections respectively) is less than or equal to a first preset distance threshold. The first preset distance threshold is determined according to actual needs. For example, the first preset distance threshold may be 15 mm, 10 mm, or 5 mm.

The second setting connector 42 provides a tensile force on the circuit board 31 mainly at the peripheral edge of the circuit board 31. A minimum distance between a point on an outer contour of a projection of the second setting connector 42 on the circuit board 31 and an outer peripheral end face of the circuit board 31 is less than or equal to a second preset distance threshold. The second preset distance threshold is determined according to actual needs. For example, the second preset distance threshold may be 20 mm, 15 mm, or 5 mm.

Generally, a distance between the first setting connector 41 and a power device 32 adjacent to the first setting connector 41 is smaller than a distance between the second setting connector 42 and the power device 32. However, in a case that an end of the power device 32 is arranged close to an end of the circuit board 31, one or more first setting connectors 4 corresponding to this end of the power device 32 may serve as one or more second setting connectors 5. That is, in this case, the one or more first setting connectors 4 can not only apply the tensile force on the peripheral edge of the circuit board 31, but also apply the tensile force on the circuit board 31 at the region where the power device 32 is located.

In this way, the first setting connector 41 is provided near the power device 3 to realize connection between the circuit board assembly 3 and the first housing 1 which ensures the contact between the circuit board assembly 3 and the first housing 1 at the region where the power device 32 is located, thereby ensuring the heat dissipation performance on the power device 32. The second setting connector 42 is provided at the edge of the circuit board 31 to realize connection between circuit board assembly 3 and the first housing 1, which ensures the stability of the relative positions of the circuit board assembly 3 and the first housing 1.

In an embodiment, a support structure is provided at the inner side of the first housing 1, and the circuit board 31 is supported by the first housing 1 through the support structure.

The support structure may be integrally formed at the inner side of the first housing 1, or may be fixed onto the first housing 1 by snap fit or other means.

Multiple support structures are usually provided to support the circuit board 31.

In this way, the circuit board 31 is supported by the support structure, such that tolerance requirements at other positions at the inner side of the first housing 1 are relaxed, making it easier to fix the circuit board 31

As shown in FIG. 4, in a further solution of the support structure, the support structure includes a first support structure 13, and a projection of the first support structure 13 on the circuit board 31 is located at the outer peripheral edge surrounding the projection of the power device 32 on the circuit board 31.

A minimum distance between the projection of the first support structure 13 on the circuit board 31 and the projection of the power device 32 on the circuit board 31 (i.e., a minimum value of a distance between two points on outer contours of the two projections respectively) is less than or equal to a third preset distance threshold. The third preset distance threshold is determined according to actual needs. For example, the third preset distance threshold may be 15 mm, 10 mm, or 5 mm.

A length of the first support structure 13 is determined according to actual needs, which is generally set to prevent the power device 32 and the circuit board 31 from being damaged by pressing. For example, the length of the first support structure 13 is substantially equal to a distance between an inner surface of the first housing 1 at the region where the power device 32 is located and the circuit board 31. Alternatively, the length of the first support structure 13 may be slightly smaller than the above distance. For example, a difference between the length and the distance may range from 0 to 1.5 mm, or from 0.2 to 1 mm, or from 0.3 to 0.6 mm, which is determined according to actual needs.

In this way, the first support structure 13 can support the circuit board 31 at a position near the power device 32, thereby ensuring the connection performance between the first housing 1 and the circuit board 31 near the power device 32. With the design of the length of the first support structure 13, the power device 32 and the circuit board 31 are prevented from being damaged due to excessively large pressing force applied by the first connector 4.

In a further solution of the first support structure 13, the first support structure 13 includes at least one of a first support rod and a first support plate, and the first support plate extends along a peripheral direction of the power device 32.

FIG. 4 shows a case that the first support structure 13 includes the first support rod. In a case that the first support structure 13 includes the first support plate, the first support plate can support the circuit board 31 well along the peripheral direction of the power device 32. In particular, when the power device 32 is mounted at the side of the circuit board 31 facing the first housing 1 in the thickness direction, the first support plate may be provided surrounding one or multiple adjacent power devices 32. In this case, an accommodation cavity is actually formed at the first support plate on the first housing 1, and the power device 32 is accommodated inside the accommodation cavity. In this way, the power device 32 is better protected in the peripheral direction thereof, and the circuit board 31 is reliably supported at the peripheral side of the power device 32.

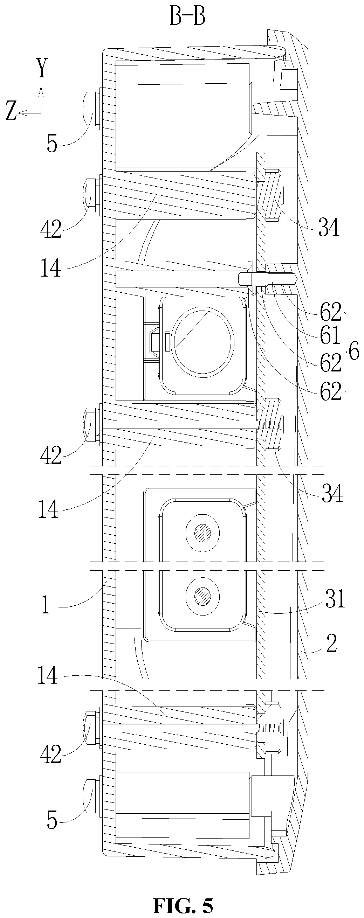

As shown in FIG. 5, in a further solution of the support structure, the support structure includes a second support structure 14, and the second support structure 14 is arranged corresponding to the peripheral edge of the circuit board 31.

A minimum distance between a point on an outer contour of a projection of the second support structure 14 on the circuit board 31 and the outer peripheral end face of the circuit board 31 is less than or equal to a fourth preset distance threshold. The fourth preset distance threshold is determined according to actual needs. For example, the fourth preset distance threshold may be 20 mm, 15 mm, or 5 mm.

Generally, multiple second support structures 14 are provided. The multiple second support structures 14 are distributed corresponding to the peripheral direction of the circuit board 31. The second support structure 14 may be a second support rod, which is not described in detail herein.

In a further solution, in a case that the first connector 4 includes the first setting connector 41, and the support structure includes the first support structure 13 and the second support structure 14, a distance between a tail end face of the first support structure 13 and the second housing 2 is larger than or equal to a distance between a tail end face of the second support structure 14 and the second housing 2 (the distance between the corresponding tail end and the second housing is specifically between the corresponding tail end and an inner surface of the second housing, where the inner surface is parallel to the XY plane). Herein, the tail end face is a surface of an end of the respective support structure away from the first housing.

When the distance between the tail end of the first support structure 13 and the second housing 2 is larger than the distance between the tail end of the second support structure 14, the circuit board 31 and the power device 32 should be prevented from being damaged. In general, a difference between the above two distances should not be too large, is determined according to actual needs. For example, the difference may range from 0 to 1.5 mm, or from 0.2 to 1 mm, or from 0.3 to 0.6 mm.

That is to say, when the circuit board assembly 3 and the first housing 1 are connected through the first setting connector 41, both the first support structure 13 and the second support structure 14 support the circuit board 31. The tensile force applied on the circuit board 31 at the position where the first support structure 13 is located may be larger than the tensile force applied on the circuit board 31 at other positions, such as the tensile force applied on the circuit board 31 at the position where the second support structure 14 is located, to prevent a case that a gap is formed between the circuit board 31 and the power device 32 due to a too small tensile force at the position where the first support structure 13 is located, which may affect the thermal conduction performance between the circuit board assembly 3 and the first housing 1 at the region where the power device 32 is located.

In a case that the distance between the tail end face of the first support structure 13 and the second housing 2 is larger than the distance between the tail end face of the second support structure 14 and the second housing 2, the tensile force applied on the region of the circuit board 31 where the first support structure 13 is located is relatively large. Therefore, the circuit board 31 is slightly deformed, at the region where the power device 32 is located, towards the side of the circuit board 31 close to the first housing 1 in the thickness direction (i.e. upwards), to ensure that the circuit board assembly 3 is in good contact with the first housing 1 at the region where the power device 32 is located, such that the thermal conduction performance between the circuit board assembly 3 and the first housing 1 is relatively good at the region where the power device 32 is located.

In the above embodiments, optionally, at least one support structure is provided with the first connection hole 11 for the first connector 4 to pass through.

As shown in FIG. 4, in an example, the first support structure 13 is provided with a first connection hole 11 for the first setting connector 41 to pass through, and the second support structure 14 is provided with another first connection hole 11 for the second setting connector 42 to pass through.

In this way, the support and connection structures between the first housing 1 and the circuit board assembly 3 are relatively compact and simple, and are highly practicable.

In the above embodiments, optionally, the circuit board 31 includes a circuit board body 311 and a reinforcement structure being connected to the circuit board body 311. At least one of the circuit board body 311 and the reinforcement structure is connected to the first setting connector 41.

The specific structure and arrangement of the reinforcement structure are not limited. The reinforcement structure can reinforce the circuit board body 311, to prevent the circuit board body 311 from being damaged by the tensile force from the first connector 4, moreover, with the reinforcement structure, the power device 32 can be better fitted against the inner surface of the first housing 1. The reinforcement structure and the circuit board body 311 may be connected by bonding, snap fit, or other connection means.

Further, the circuit board body 311 is provided with the reinforcement structure at least in the region corresponding to the power device 32, so as to particularly reinforce the region where the power device 32 is located.

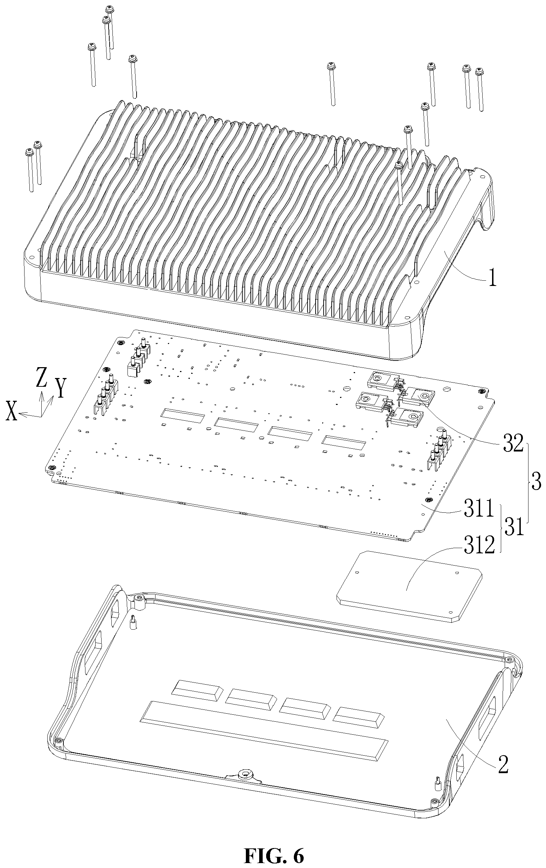

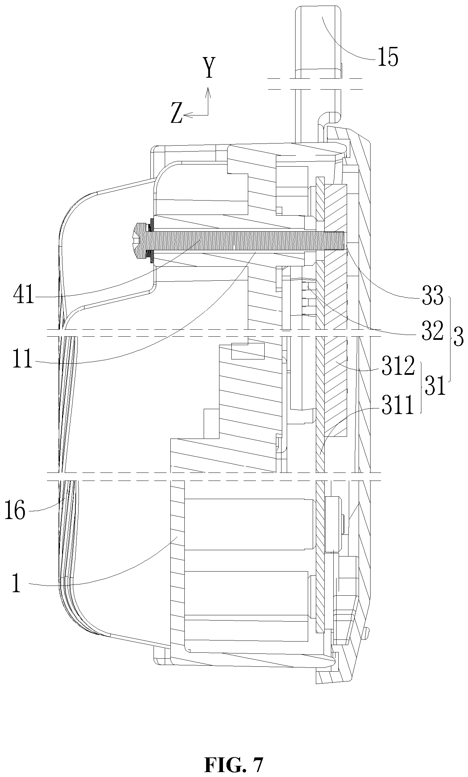

As shown in FIGS. 6 and 7, further, the reinforcement structure includes a reinforcement plate 312, and the reinforcement plate 312 and the power device 32 are respectively located at opposite sides of the circuit board body 311. A projection of the power device 32 on the circuit board body 311 is within a projection of the reinforcement plate 312 on the circuit board body 311. In another embodiment, the reinforcement plate 312 and the power device 32 may be located at the same side of the circuit board body 311. In this case, the reinforcement plate 312 is connected to the power device 32, and the first connector 4 passes through the first housing 1 to be connected to the reinforcement plate 312, which enables the power device 32 to be better fitted against the inner surface of the first housing 1, and thereby facilitating heat dissipation.

In an example, the power device 32 is mounted at the side of the circuit board body 311 facing the first housing 1 in the thickness direction, and the reinforcement plate 312 is located at the side of the circuit board body 311 away from the first housing 1 in the thickness direction. The first connector 4 passes through the first housing 1 and the circuit board body 311 in sequence to be connected to the reinforcement plate 312.

In this way, the power device 32 and the reinforcement plate 312 are less likely to interfere with each other, and the reinforcement effect to the circuit board body 311 is ensured.

It may be appreciated that, if necessary, the reinforcement structure, such as the reinforcement plate 312, should be provided with an avoidance structure to avoid devices on the circuit board body 311, which is not described in detail herein.

In an embodiment, the first housing 1 and the second housing 2 are connected by snap fit.

In an example, a snap-fit member is provided at the inner side of the first housing 1, and a snap-fit opening is provided at an inner side of the second housing 2. A free end of the snap-fit member extends into the snap-fit opening and is connected to the snap-fit opening, such that the first housing 1 and the second housing 2 are connected. This solution is not shown in the drawings, and is not described in detail hereinafter.

As shown in FIG. 1, in an embodiment, the power electronic device further includes a second connector 5, and the first housing 1 and the second housing 2 are connected through the second connector 5.

Specifically, the first housing 1 is provided with a third connection hole 12, and the second housing 2 is provided with a fourth connection hole 24. The second connector 5 passes through one of the third connection hole 12 and the fourth connection hole 24, to be connected to the other one of the third connection hole 12 and the fourth connection hole 24.

In this way, the positions of the first housing 1 and the second housing 2 are fixed with respect to each other, and the fixation structure thereof is relatively simple and highly practicable.

As shown in FIG. 1, in an optional solution of the second connector 5, the second connector 5 passes through the first housing 1 and is connected to the second housing 2.

Specifically, starting from the outer side (the side where the positive direction of the Z-axis in the drawings is) of the first housing 1, the second connector 5 passes through the third connection hole 12 from outside to inside and is connected to the fourth connection hole 24.

In this way, for the power electronic device, when the circuit board assembly 3, the first housing 1 and the second housing 2 are being assembled, connection operations of the first connector 4 and the second connector 5 can be respectively completed at the outer side (the side where the positive direction of the Z-axis in the drawings is) of the first housing 1, such that the first housing 1 and the circuit board assembly 3 are connected through the first connector 4, and the second housing 2 and the first housing 1 are connected through the second connector 5. Therefore, it's not needed to perform the connection operations of the first connector 4 and the second connector 5 at the outer side of the first housing 1 and the outer side of the second housing 2 respectively, which facilitates assembling of the circuit board assembly 3, the first housing 1 and the second housing 2, leading to high assembling efficiency and high practicality.

In a further optional solution of the second connector 5, a blind hole is provided at the inner side of the second housing 2, and the second housing 2 is connected to the second connector 5 through the blind hole.

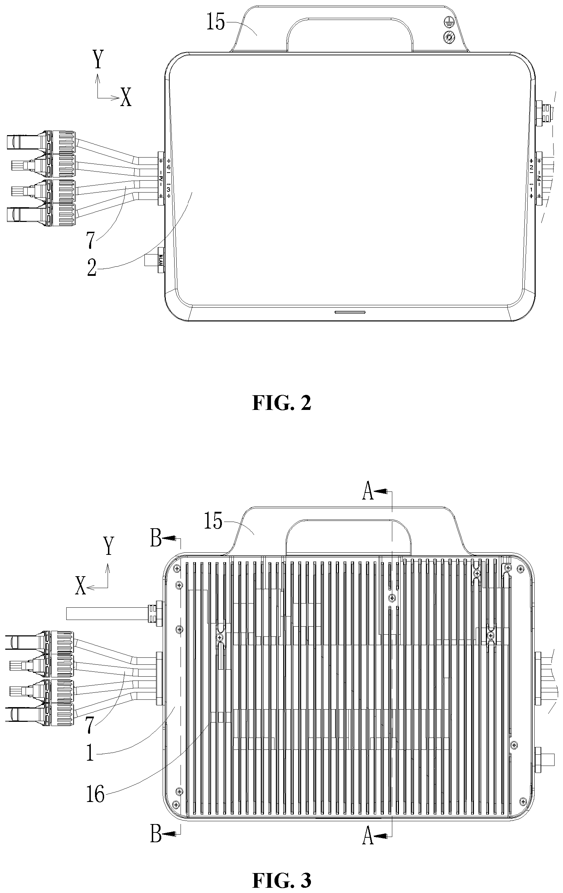

Specifically, the fourth connection hole 24 is the blind hole, and the blind hole is provided at the inner side of the second housing 2. That is, there's no need to provide holes on the outer surface of the second housing 2 to serve as the fourth connection hole 24 (referring to FIG. 2), which prevents the smoothness of the surface of the second housing 2 at the negative direction of the Z-axis from being damaged.

In this way, the smoothness of the outer surface of the second housing 2 is prevented from being damaged by the connection with the second connector 5, making the appearance of the outer surface of the second housing 2 better.

In this case, when the power electronic device is used in practice, the first housing 1 may be located at a back side of the power electronic device, and the second housing 2 may be located at a front side of the power electronic device. For example, in a case that the power electronic device is a microinverter, when the microinverter is hanged and mounted on a mounting rack of a photovoltaic module through a lug structure 15, being located at the positive direction of the Y-axis, of the first housing 1, the second housing 2 is located at a side of the power electronic device away from the mounting rack, i.e. at the front side of the power electronic device. When the first housing 1, the circuit board assembly 3 and the second housing 2 are being connected, there's no need to provide a through hole on the outer surface of the second housing 2 for connection with the second connector 5, which improves cleanliness of the outer surface of the second housing 2, and makes the appearance of the front side of the power electronic device better.

Similarly, the first housing 1 and the second housing 2 may be provided with a support rod corresponding to the second connector 5, which is not described in detail herein.

As shown in FIG. 5, in an embodiment, the power electronic device further includes an insertion positioning structure 6. The insertion positioning structure 6 is provided between the first housing 1 and the circuit board 31, and/or the insertion positioning structure 6 is provided between the first housing 1 and the second housing 2. Specifically, in one embodiment, the power electronic device may include an insertion positioning structure 6, where the insertion positioning structure 6 is provided between the first housing 1 and the circuit board 31 or between the first housing 1 and the second housing 2; in another embodiment, the power electronic device may include at least two insertion positioning structures 6, where one of the insertion positioning structures 6 is provided between the first housing 1 and the circuit board 31 and another one of the insertion positioning structures 6 is provided between the first housing 1 and the second housing 2.

The specific structure of the insertion positioning structure 6 is not limited. The insertion positioning structure between the first housing 1 and the circuit board 31, and the insertion positioning structure between the first housing 1 and the second housing 2 may be similar or different, as long as, taking the insertion positioning structure 6 between the first housing 1 and the circuit board 31 as an example, a part of the insertion positioning structure 6 arranged at the first housing 1 and another part of the insertion positioning structure 6 arranged at the circuit board 31 can be smoothly connected to achieve relatively positioning of the first housing 1 and the circuit board 31.

In this way, the assembling operation of the power electronic device is facilitated after the first housing 1, the circuit board 31 and the second housing 2 are relatively positioned by the insertion positioning structure 6. For example, the second housing 2, the circuit board assembly 3 and the first housing 1 may be placed in position from bottom to top in sequence. After they are relatively positioned, the connection operations of the first connector 4 and the second connector 5 are completed at the top, so as to achieve quick assembling of the power electronic device, which, in an automated production line for example, reduces the complexity of assembling apparatus for the power electronic device, and improves assembling efficiency of the power electronic device

As shown in FIG. 5, in a further optional solution of the insertion positioning structure 6, the insertion positioning structure 6 includes a positioning pin 61 and a positioning hole 62.

Further, in a case that the insertion positioning structure 6 is provided between the first housing 1 and the circuit board 31 and another insertion positioning structure 6 is provided between the first housing 1 and the second housing 2, the first housing 1, the circuit board 31 and the second housing 2 are each provided with the positioning hole 62, and the positioning pin is inserted into the positioning holes of at least two of the first housing 1, the circuit board 31 and the second housing 2.

As shown in FIG. 5, a case that the positioning pin 61 is inserted into the positioning holes 62 of the first housing 1, the circuit board 31 and the second housing 2 is illustrated. That is, a case that the first housing 1, the circuit board 31 and the second housing 2 are relatively positioned through the same positioning pin 61 is illustrated. The positioning structure is simple and highly practicable.

In the above embodiments, optionally, the heat dissipation structure 16 includes multiple heat dissipation fins that are connected to an outer surface of the first housing 1.

In an embodiment, the heat dissipation structure 16 includes a heat dissipation flow passage. For example, a coolant is provided inside the heat dissipation flow passage, and the coolant flows to dissipate heat of the power device 32 of the circuit board assembly 3.

In the above embodiments, optionally, the second housing 2 includes a first plate 21 and a second plate 22. The first plate 21 is arranged facing the circuit board 31. The second plate 22 is located at an end of the first plate 21, and is provided with a mounting hole 23 for mounting of a cable bundle assembly 7, where the cable bundle assembly 7 is connected to the circuit board 31.

Specifically, the cable bundle assembly 7 extends into the mounting cavity through the mounting hole 23 of the second housing 2 and is connected to the circuit board 31.

In this way, when the power electronic device is assembled, the inner side of the second housing 2 faces upwards. After the cable bundle assembly 7 is connected to the circuit board 31, the first housing 1, the circuit board assembly 3 and the second housing 2 are relatively positioned through the insertion positioning structure 6. Then, the connections of the first connector 4 and the second connector 5 are completed at the top, thereby facilitating assembling efficiency of the power electronic device.

A power system is provided according to another embodiment of the present application, including the power electronic device according to the embodiments hereinabove. For example, the power system may be a photovoltaic system.

## Claims

1. A power electronic device, comprising a first housing (1), a second housing (2), a circuit board assembly (3) and a first connector (4); wherein
the first housing (1) is provided with a heat dissipation structure (16);
a mounting cavity is defined by the first housing (1) and the second housing (2), and the circuit board assembly (3) is accommodated inside the mounting cavity;
the circuit board assembly (3) comprises a circuit board (31) and a power device (32) being mounted to the circuit board (31), the first connector (4) passes through the first housing (1) from outside to inside and is connected to the circuit board (31), to fix the circuit board (31) at an inner side of the first housing (1); and
when the circuit board (31) is fixed at the inner side of the first housing (1), the first housing (1) is in contact with the circuit board assembly (3) in a region corresponding to the power device (32), and the heat dissipation structure (16) covers at least the region of the first housing (1) corresponding to the power device (32).

2. The power electronic device according to claim 1, wherein in a thickness direction of the circuit board (31), the power device (32) is mounted at a side of the circuit board (31) facing the first housing (1).

3. The power electronic device according to claim 1 or claim 2, wherein the first connector (4) comprises at least one of a first setting connector (41) and a second setting connector (42), a projection of the first setting connector (41) on the circuit board (31) is located at an outer peripheral edge surrounding a projection of the power device (32) on the circuit board (31), and the second setting connector (42) is arranged at a peripheral edge of the circuit board (31).

4. The power electronic device according to claim 3, wherein
a support structure is provided at the inner side of the first housing (1), and the circuit board (31) is supported by the first housing (1) through the support structure; and
the support structure comprises at least one of a first support structure (13) and a second support structure (14), a projection of the first support structure (13) on the circuit board (31) is located at the outer peripheral edge surrounding the projection of the power device (32) on the circuit board (31), and the second support structure (14) is arranged corresponding to the peripheral edge of the circuit board (31).

5. The power electronic device according to claim 4, wherein
the first support structure (13) comprises at least one of a first support rod and a first support plate, and the first support plate extends along a peripheral direction of the power device (32); and/or
the second support structure (14) comprises a second support rod.

6. The power electronic device according to claim 4, wherein in a case that the first connector (4) comprises the first setting connector (41), and the support structure comprises the first support structure (13) and the second support structure (14), a distance between an end face of the first support structure (13) and the second housing (2) is larger than or equal to a distance between an end face of the second support structure (14) and the second housing (2).

7. The power electronic device according to claim 4, wherein the support structure is provided with a first connection hole (11) for the first connector (4) to pass through.

8. The power electronic device according to claim 1 or claim 2, wherein the circuit board (31) comprises a circuit board body (311) and a reinforcement structure being connected to the circuit board body (311), and at least one of the circuit board body (311) and the reinforcement structure is connected to the first connector (4).

9. The power electronic device according to claim 8, wherein the reinforcement structure comprises a reinforcement plate (312), the reinforcement plate (312) and the power device (32) are respectively located at opposite sides of the circuit board body (311) in a thickness direction, or the reinforcement plate (312) and the power device (32) are located at a same side of the circuit board body (311) in a thickness direction; and wherein
a projection of the power device (32) on the circuit board body (311) is within a projection of the reinforcement plate (312) on the circuit board body (311).

10. The power electronic device according to claim 1 or claim 2, wherein
the first housing (1) and the second housing (2) are connected by snap fit; and/or
the power electronic device further comprises a second connector (5), and the first housing (1) and the second housing (2) are connected through the second connector (5).

11. The power electronic device according to claim 10, wherein
in a case that the power electronic device comprises the second connector (5), the second connector (5) passes through the first housing (1) and is connected to the second housing (2); wherein
the second housing (2) is provided with a through hole configured to be connected to the second connector (5), or an inner side of the second housing (2) is provided with a blind hole configured to be connected to the second connector (5).

12. The power electronic device according to claim 1 or claim 2, wherein
the power electronic device comprises an insertion positioning structure (6); and
the insertion positioning structure (6) is provided between the first housing (1) and the circuit board (31), and/or the insertion positioning structure (6) is provided between the first housing (1) and the second housing (2).

13. The power electronic device according to claim 12, wherein
the insertion positioning structure (6) comprises a positioning pin (61) and a plurality of positioning holes (62); and
each of the first housing (1), the circuit board (31) and the second housing (2) is provided with one of the plurality of positioning holes (62), and the positioning pin (61) is inserted into the corresponding positioning holes (62) of at least two of the first housing (1), the circuit board (31) and the second housing (2).

14. The power electronic device according to claim 1 or claim 2, wherein
the heat dissipation structure (16) comprises a plurality of heat dissipation fins connected to an outer surface of the first housing (1), or a heat dissipation flow passage, or a combination of a plurality of heat dissipation fins connected to an outer surface of the first housing (1) and a heat dissipation flow passage; and/or
the first connector (4) is a threaded connector or a snap-fit connector; and/or
the second housing (2) comprises a first plate (21) and a second plate (22), the first plate (21) is arranged facing the circuit board (31), the second plate (22) is located at an end of the first plate (21), and the second plate (22) is provided with a mounting hole (23) for mounting a cable bundle assembly (7).

15. A power system, comprising the power electronic device according to any one of claims 1 to 14.
